Europäisches Patentamt

European Patent Office

Office européen des brevets

(11) Publication number: **0 279 481 B1**

## EUROPEAN PATENT SPECIFICATION

(45) Date of publication of patent specification: **17.06.92**   (51) Int. Cl.⁵: **G01R  33/36**

(21) Application number: **88200182.9**

(22) Date of filing: **03.02.88**

(54) **Magnetic resonance imaging apparatus incorporating improved detection.**

(30) Priority: **06.02.87 NL 8700281**

(43) Date of publication of application:
**24.08.88 Bulletin  88/34**

(45) Publication of the grant of the patent:
**17.06.92 Bulletin  92/25**

(84) Designated Contracting States:
**DE FR GB NL**

(56) References cited:
**EP-A- 0 164 164**
**EP-A- 0 232 189**
**GB-A- 2 153 086**
**US-A- 3 764 892**
**US-A- 4 194 179**

**REVIEW OF SCIENTIFIC INSTRUMENTS, vol. 56, no. 9, September 1985, pages 1763-1771, American Institute of Physics, New York, US; D. BLOYET et al.: "Very-low-noise amplifier for low-temperature pulsed NMR experiments"**

**REVIEW OF SCIENTIFIC INSTRUMENTS, vol. 52, no. 4, April 1981, pages 542-547, American Instiute of Physics, New York, US; J. BRONDEAU et al.: "Flexible fourier multi-**

**nuclear magnetic resonance spectrometer"**

(73) Proprietor: **N.V. Philips' Gloeilampenfabrieken**
**Groenewoudseweg 1**
**NL-5621 BA Eindhoven(NL)**

(72) Inventor: **Van Heelsbergen, Teunis Robert**
**c/o INT. OCTROOIBUREAU B.V. Prof. Holst-laan 6**
**NL-5656 AA Eindhoven(NL)**
Inventor: **Wardenier, Peter Hanzen**
**c/o INT. OCTROOIBUREAU B.V. Prof. Holst-laan 6**
**NL-5656 AA Eindhoven(NL)**

(74) Representative: **Scheele, Edial François et al**
**INTERNATIONAAL OCTROOIBUREAU B.V.**
**Prof. Holstlaan 6**
**NL-5656 AA Eindhoven(NL)**

## Description

The invention relates to a magnetic resonance imaging apparatus, comprising a magnet system for generating a steady magnetic field, a magnet system for generating magnetic gradient fields, an r.f. transmitter coil and an r.f. detection coil with a detection device for detecting magnetic resonance signals generated in an object.

An apparatus of this kind is known from EP 164164.

When the known apparatus is used, it is found to be a drawback that the detection device must be readjusted each time a patient to be examined is introduced into the apparatus. This means that the apparatus must be returned each time for adaptation to the correct frequency and the impedance must be matched each time to, for example, the 50 ohm input impedance of the detector. When capacitors having a value which is substantially greater then the parasitic capacitances occurring due to the presence of a patient, are included in the coil circuit, this can prevent the dissipation of a substantial part of the coil current via the patient as a result of said parasitic capacitance. The drawback of the necessary repeated tuning of the detection device can thus be avoided. When a patient is arranged in the apparatus, the Q value of the coil is reduced due to energy loss caused by eddy currents occurring in the patient. From a circuit-technical point of view, an additional loss resistance is thus added, so that the coil must be matched again each time the coil load changes. There is no known circuit-technical intervention for eliminating this drawback equivalent to the addition of a capacitance for tuning.

It is a further drawback of this known apparatus that a comparatively high signal loss occurs due to the necessarily long signal output cable between the coil and the detector. An NMR imaging apparatus is disclosed in EP-A-0 232 189 claiming the priority date of 07.01.86 and published on 12.08.87. In this known apparatus, a preamplifier, which amplifies the detection signal, is included between the coil end and a signal output cable.

It is an object of the invention to mitigate the above-mentioned drawbacks; to achieve this, a magnetic resonance imaging apparatus of the kind set forth in accordance with the invention is characterized as claimed in claim 1.

The apparatus in a preferred embodiment comprises a separate transmitter coil and detection coil this avoids the drawback that a measurement coil including a preamplifier is less suitable for use as a transmitter coil. The measurement coil comprises notably at least one surface coil. A detection coil of this kind is itself already less suitable for use as a transmitter coil.

In a further embodiment, the detection coil comprises a subdivided coil as decribed in EP 173363, so that substantially lower voltages occur in the coil system with the result that additional losses due to the introduction of an object to be measured are substantially reduced because the dielectric currents then occurring are lower.

In a further preferred embodiment the signal preamplifier in the detection coil comprises an insulated gate field effect transistor, for example a MOSFET transistor, so that a substantial signal amplification can be realized by means of a circuit which takes substantially no current.

Some preferred embodiments in accordance with the invention will be described in detail hereinafter with reference to the drawings.

Therein:

Figure 1 shows a magnetic resonance imaging apparatus comprising a detection device which includes a preamplifier in accordance with the invention,

Figure 2 shows a known r.f. detection circuit for a magnetic resonance imaging apparatus, and

Figure 3 shows a circuit diagram for an r.f. detection device in accordance with the invention.

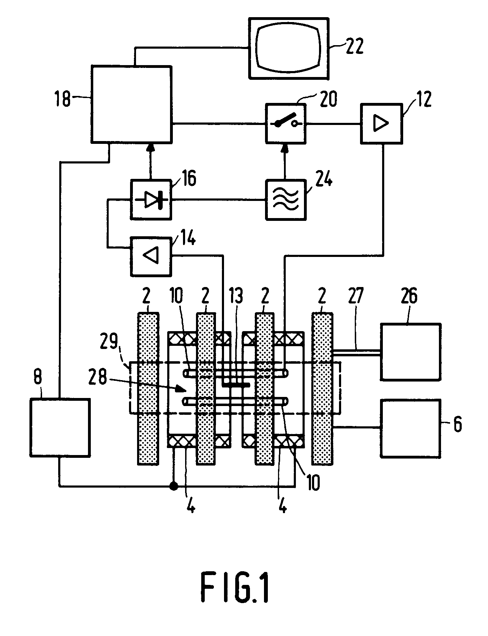

A magnetic resonance imaging apparatus as shown in Figure 1 comprises a magnet system 2 for generating a steady, uniform magnetic field, a magnet system 4 for generating magnetic gradient fields, and power supply sources 6 and 8 for the magnet system 2 and the magnet system 4, respectively. A magnet coil 10 serves to generate an r.f. magnetic alternating field and is connected to an r.f. source 12. A coil 13 is included for detecting magnetic resonance signals generated to be examined by the r.f. transmitter field. For reading purposes the coil 13 is connected to a signal amplifier 14. The signal amplifier 14 is connected to a phase sensitive rectifier 16 which is connected to a central control device 18. The central control device 18 also controls a modulator 20 for the r.f. source 12, the power supply source 8 for the gradient coils, and a monitor 22 for image display. An r.f. oscillator 24 controls both the modulator 20 and the phase sensitive rectifier 16 which processes the measurement signals. For cooling, if any, there is provided a cooling device 26 which comprises cooling ducts 27. A cooling device of this kind may be constructed as a water cooling system for resistance coils or as a liquid helium dewar system for superconducting coils. The transmitter coil 10 which is arranged within the magnet systems 2 and 4 encloses a measurement space 28 which offers adequate space for accommodating a patient in the case of a medical diagnostic apparatus. This, in the measurement space 28 there can be generated a steady magnetic field, gradient fields for position selection of slices to be imaged, and a spatially uniform r.f. alternating field.

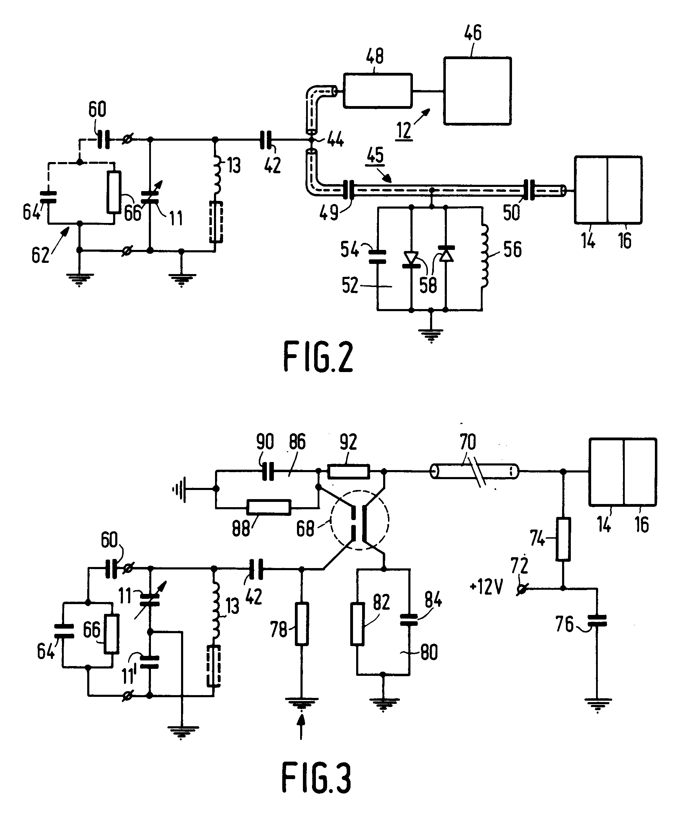

In a customary circuit for detecting the r.f. signals as shown in Figure 2 and described in detail in "Review of Scientific Instr." 52, no. 4, April 1981, pages 542-547, the detection coil 13 and a capacitor 11 which is connected in parallel therewith are connected, via a matching capacitor 42, to a circuit point 44 to which the r.f. transmitter device 12 and a detection device 45 are connected. The r.f. transmitter device 12 of the present embodiment comprises an r.f. transmitter 46 and a noise suppressor 48.

The signal amplifier 14 and the rectifier 16 of the detection device are connected to the circuit point 44 via a capacitor 49 and a capacitor 50. A protection circuit 52 which includes a capacitor 54, a coil 56 and a diode circuit 58 is connected between the capactiors 49 and 50 of the present embodiment. An object to be measured, normally a patient to be examined, is represented in the circuit by an equivalent circuit having a parasitic capacitance 60 and a parallel connection 62 of a capacitance 64 and a resistance 66. The latter connection is relevant for dielectric currents which occur via parasitic capacitances to the patient and which are to be interpreted as a loss factor. When it is ensured that the capacitance of the capacitor 11 is large with respect to the parasitic capacitance, frequency shifts can be precluded with a patient is introduced. In this situation the entire current will flow via the capacitance 11 and substantially no current will flow via the capacitance 60.

Figure 3 shows a detection coil 13, two tuning capacitors 11 and 11′ (for reasons of symmetry), and the equivalent circuit of a patient represented by a parasitic capacitance 60 and a parallel connection of a capacitance 64 and a resistor 66 of a circuit diagram for an r.f. detection system in accordance with the invention. The coil system is connected via a matching capacitor 42 to a transistor 68 which is in this case formed by a MOSFET transistor. The resonance signals are amplified by the transistor 68 and are applied as amplified signals to the detector device 14, 16 via a cable 70. A supply voltage of, for example +12 V is applied from a terminal 72 via a 50 ohm resistor 74. The supply connection is grounded via a smoothing capacitor 76.

In order to achieve correct adjustment of the transistor 68, it is connected to ground via a resistor 78, an RC circuit 870 comprising a resistor 82 and a capacitor 84, and an RC circuit 86 comprising a resistor 88 and a capacitor 90. The RC circuit 86 is connected to the signal output cable 70 via a coupling resistor 92 which bridges the transistor.

## Claims

1. A magnetic resonance imaging apparatus, comprising a magnet system (2) for generating a steady magnetic field, a magnet system (4) for generating magnetic gradient fields, an r.f. transmitter coil (10) and an r.f. measurement coil (13), an r.f. detection device (14,16) for detecting magnetic resonance signals generated in an object to be examined, a signal output cable (70) connecting the detection device (14,16) to the measurement coil (13), a matching capacitor (42) being provided between the measurement coil (13) and the signal output cable (70), the apparatus further comprising a voltage controlled preamplifier (68,78-92) connected between the matching capacitor (42) and the coil end of the signal output cable (70).

2. A magnetic resonance imaging apparatus as claimed in Claim 1, characterized in that the apparatus comprises a separate r.f. transmitter coil (10) and an r.f. measurement coil (13).

3. A magnetic resonance imaging apparatus as claimed in Claim 2, characterized in that the r.f. measurement coil (13) is a surface coil.

4. A magnetic resonance imaging apparatus as claimed in Claim 1, 2 or 3, characterized in that the measurement coil system comprises a coil (10) subdivided into a plurality of sub-coils.

5. A magnetic resonance imaging apparatus as claimed in any one of the preceding Claims, characterized in that it further comprises a capacitor (11,11') which is connected in parallel with the measurement coil (13) and the capacitance of which is adapted in order to minimize the loss of coil quality due to the introduction of the object.

6. A magnetic resonance imaging apparatus as claimed in any one of the preceding Claims, characterized in that the signal preamplifier circuit (68,78-92) comprises a MOSFET transistor (68).

## Revendications

1. Appareil d'imagerie par résonance magnétique, comprenant un système d'aimants (2) pour produire un champ magnétique statique, un système d'aimants (4) pour produire des champs de gradients magnétiques, une bobine d'émission r.f. (10) et une bobine de mesure r.f. (13), un dispositif de détection r.f. (14, 16) pour détecter des signaux de résonance magnétique produits dans un objet à examiner, un câble de sortie de signaux (70) connectant le dispositif de détection (14, 16) à la bobine de mesure (13), un condensateur d'adaptation (42) prévu entre la bobine de mesure (13) et le câble de sortie de signaux (70), l'appareil comprenant, en outre, un préamplificateur contrôle en tension (68, 78-92) connecté entre le condensateur d'adaptation (42) et l'extrémité côté bobine du câble de sortie de signaux (70).

2. Appareil d'imagerie par résonance magnétique suivant la revendication 1, caractérisé en ce qu'il comprend une bobine d'émission r.f. séparée (10) et une bobine de mesure r.f. (13).

3. Appareil d'imagerie par résonance magnétique suivant la revendication 2, caractérisé en ce que la bobine de mesure r.f. (13) est une bobine de surface.

4. Appareil d'imagerie par résonance magnétique suivant la revendication 1,2 ou 3, caractérisé en ce que le système de bobine de mesure comprend une bobine (10) subdivisée en plusieurs sous-bobines.

5. Appareil d'imagerie par résonance magnétique suivant l'une quelconque des revendications précédentes, caractérisé en ce qu'il comprend, en outre, un condensateur (11, 11') qui est connecté en parallèle avec la bobine de mesure (13) et dont la capacité est adaptée afin de réduire au minimum la perte de qualité de bobine due à l'introduction de l'objet.

6. Appareil d'imagerie par résonance magnétique suivant l'une quelconque des revendications précédentes, caractérisé en ce que le circuit préamplificateur de signaux (68, 78-92) comprend un transistor MOSFET (68).

**Patentansprüche**

1. Kernspinresonanzbilderzeugungsgerät mit einem Magnetsystem (2) zum Erzeugen eines statischen Magnetfelds, einem Magnetsystem (4) zum Erzeugen magnetischer Gradientenfelder, einer Hf-Senderspule (10) und einer Hf-Meßspule (13), einer Hf-Detektoranordnung (14, 16) zum Detektieren von in einem zu untersuchenden Objekt erzeugten magnetischen Resonanzsignalen, einem Signalausgangskabel (70), das die Detektoranordnung (14, 16) mit der Meßspule (13) verbindet, einem Anpassungskondensator (42) zwischen der Meßspule (13) und dem Signalausgangskabel (70), wobei das Gerät weiter einen zwischen dem Anpassungskondensator (42) und dem Spulenende des Signalausgangskabels angeschlossenen spannungsgesteuerten Vorverstärker (68, 78-92) enthält.

2. Kernspinresonanzbilderzeugungsgerät nach Anspruch 1, dadurch gekennzeichnet, daß das Gerät eine getrennte Hf-Senderspule (10) und eine Hf-Meßspule (13) enthält.

3. Kernspinresonanzbilderzeugungsgerät nach Anspruch 2, dadurch gekennzeichnet, daß die Hf-Meßspule (13) eine Oberflächenspule ist.

4. Kernspinresonanzbilderzeugungsgerät nach Anspruch 1, 2, oder 3, dadurch gekennzeichnet, daß das Meßspulensystem eine in eine Anzahl von Unterspulen verteilte Spule (10) enthält.

5. Kernspinresonanzbilderzeugungsgerät nach einem oder mehreren der vorangehenden Ansprüche, dadurch gekennzeichnet, daß das Gerät außerdem einen Kondensator (11, 11') enthält, der zur Meßspule (13) parallelgeschaltet ist und dessen Kapazität zum möglichsten Verringern des Verlustes an Spulenqualität infolge der Einführung des Objekts dient.

6. Kernspinresonanzbilderzeugungsgerät nach einem oder mehreren der vorangehenden Ansprüche, dadurch gekennzeichnet, daß die Signalvorverstärkerschaltung (68, 78-92) einen MOSFET-Transistor (68) enthält.

FIG.1

FIG.2

FIG.3